(19) **Europäisches Patentamt**

**European Patent Office**

**Office européen des brevets**

(11) **EP 0 660 519 B1**

(12) **EUROPEAN PATENT SPECIFICATION**

(45) Date of publication and mention
of the grant of the patent:
**22.08.2001  Bulletin 2001/34**

(51) Int Cl.⁷: **H03K 17/0814**, H03K 17/082

(21) Application number: **94309162.9**

(22) Date of filing: **08.12.1994**

(54) **Semiconductor device protection circuit**

Halbleitervorrichtungsschutzschaltung

Circuit de protection pour dispositif semi-conducteur

(84) Designated Contracting States:
**DE ES FR GB IT**

(30) Priority: **23.12.1993  GB 9326275**

(43) Date of publication of application:
**28.06.1995  Bulletin 1995/26**

(73) Proprietor: **Lucas Industries Limited
London W1Y 4DJ (GB)**

(72) Inventor: **Dearn, David
Sutton Coldfield, Birmingham, B73 5EG (GB)**

(74) Representative: **Hackett, Sean James et al
Marks & Clerk,
Alpha Tower,
Suffolk Street Queensway
Birmingham B1 1TT (GB)**

(56) References cited:
**EP-A- 0 108 283        EP-A- 0 287 525
EP-A- 0 321 663        EP-A- 0 523 800
FR-A- 2 648 631        US-A- 4 628 885
US-A- 5 111 353**

**Description**

The present invention relates to a semiconductor device protection circuit. Such a circuit may be used to prevent tampering with an actuator, for instance comprising part of a vehicle engine control system.

EP-A-0287525 discloses a semiconductor device protection circuit comprising an inductive load and a semiconductor device, the inductive load and the semiconductor device being connected in series between a power supply terminal and a common terminal of the main power supply. Means are provided for switching on the semiconductor device when the voltage at the power supply terminal relative to the common terminal exceeds a predetermined voltage greater than the supply voltage. The circuit is for recirculating an inductive load's discharge current through a driving power switching transistor.

According to the invention, there is provided a semiconductor device protection circuit contained in a tamper resistant enclosure, the circuit comprising a load which, in use, draws a first current and a semiconductor device, and a link arranged to become open circuit at a second current which is greater than the first current, the semiconductor device being capable of passing a third current which is greater than the second current, and the load, the link, and the semiconductor being connected in series between a power supply terminal and a common terminal, the circuit further comprising means for switching on the semiconductor device when the voltage at the power supply terminal relative to the common terminal exceeds a predetermined voltage greater than a maximum supply voltage.

Preferably the semiconductor device has a control electrode. The switching-on means may be connected to the control electrode of the semiconductor device. The switching-on means may further be connected to the power supply terminal. The switching-on means may comprise a zener diode arranged to conduct when the voltage at the power supply terminal exceeds the predetermined voltage. The switching-on means may comprise a resistor connected in series with the zener diode. The switching-on means may comprise a diode connected in series with the zener diode and arranged to prevent reverse-biasing of the control electrode.

A decoder may be connected to the control electrode.

The tamper-resistant enclosure may be conductive and may form the common terminal.

The load may comprise an actuator, for instance forming part of a vehicle engine control system.

The semiconductor device may comprise a silicon controlled rectifier, a bipolar transistor, or a field effect transistor such as MOSFET.

The invention will be further described, by way of example, with reference to the accompanying drawings, in which:

Figure 1 is a circuit diagram of a tamper-resistant circuit of known type; and

Figure 2 is a circuit diagram of a tamper-resistant circuit constituting an embodiment of the invention.

Like reference numerals refer to like parts in the drawings.

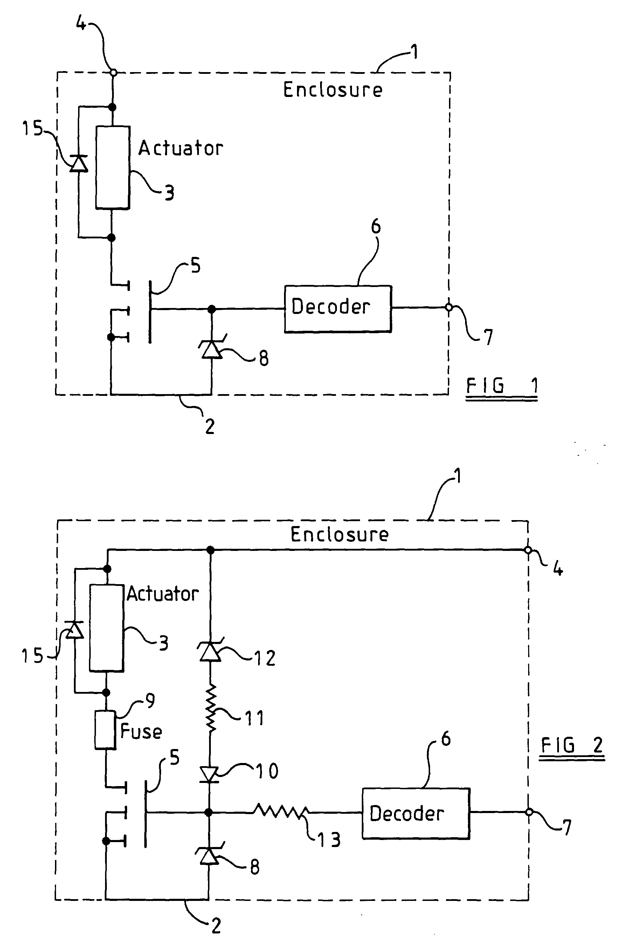

The known circuit shown in Figure 1 comprises a tamper-resistant enclosure 1 which is conductive and constitutes a common power supply terminal 2. For instance, the enclosure may comprise a steel box having a steel lid welded thereto so as to prevent or render difficult unauthorised access to the circuit within the enclosure 1.

The circuit further comprises an actuator 3, for instance forming part of an engine control system of a vehicle, having a recycling diode 15 connected thereacross. The actuator may be part of the fuel system of a compression-ignition engine such that the engine cannot be operated unless the actuator 3 is enabled. The actuator 3 is connected between a power supply terminal 4 in the form of a connector for supplying power to the circuit and the drain of a power MOSFET 5, whose source is connected to the common terminal 2.

The MOSFET 5 has a gate connected to the output of a decoder 6 whose input is connected to an input terminal 7 of the circuit in the form of a connector. The gate of the MOSFET 5 is also connected to the common terminal 2 via a zener diode 8, which protects the gate against reverse-biasing and excessive forward-biasing voltages.

In use, the common terminal 2 comprising the enclosure 1 is electrically connected to the common terminal of a vehicle supply system, for instance by bolting the enclosure to a chassis, monocoque, or engine of the vehicle. The power supply terminal 4 is connected to the vehicle power supply, for instance via the vehicle ignition switch. The input terminal 7 is connected to a controller which controls operation of the engine.

In order for the engine to be capable of operating, the control system must be capable of controlling operation of the actuator 3 by controlling conduction of the MOSFET 5. Whenever the MOSFET 5 is to be switched on, encoded signals are supplied by the controller to the decoder 6 via the input terminal 7. The decoder 6 decodes the encoded signals and, if these are correctly encoded, switches on the MOSFET 5 so as to operate the actuator 3.

If the incorrect encoded signal is supplied to the input terminal 7, this is detected by the decoder 6, which prevents the MOSFET 5 from switching on. The actuator 3 cannot therefore be operated unless the correctly encoded signals are supplied to the circuit. Thus, a potential vehicle thief who would not normally know the correct encoding would be unable to operate the engine by supplying signals to the input terminal 7.

Although the circuit shown in Figure 1 provides a degree of resistance to tampering, it is possible for the circuit to be overridden by applying a relatively high voltage to the power supply terminal 4. If a sufficiently large voltage is applied to the terminal 4 so that the maximum voltage rating of the source-drain path of the MOSFET 5 is exceeded, the MOSFET 5 will fail. In these circumstances, the source-drain path may fail open circuit or closed circuit and, if it fails closed circuit, the actuator 3 can then be operated without the thief needing to know the correct encoding for signals to the input terminal 7. In the case where the actuator 3 is of the type which is required to be continuously operated in order for the engine to be operated, a failure of this type defeats the tamper-resistant circuit shown in Figure 1 and the thief may then be able to drive away the vehicle.

The circuit shown in Figure 2 differs from that shown in Figure 1 in that various additional components are provided so as to improve the tamperresistance of the circuit. A fusible link such as a conventional fuse 9 is connected between the actuator 3 and the drain of the MOSFET 5. The gate of the MOSFET 5 is connected via a diode 10, a resistor 11, and a zener diode 12 to the power supply terminal 4. A resistor 13 is connected between the gate of the MOSFET 5 and the decoder 6.

The fuse 9 has a current rating such that it goes open circuit for currents equal to or greater than a predetermined current which is greater than the maximum current normally drawn by the actuator 3, for instance for the maximum permitted supply voltage supplied to the terminal 4. The source-drain path of the MOSFET 5 has a maximum current rating which is greater than the current rating of the fuse 9. Thus, the fuse 9 will "blow" and become open circuit before the current passing through the source-drain path of the MOSFET 5 is sufficient to damage the MOSFET.

If a reverse polarity voltage is applied between the terminals 2 and 4, the diode 15 will conduct. In these conditions, there is a danger that the resulting reverse current will produce a heating effect sufficient to melt the solder used to connect the components in the circuit so that some components may become disconnected. In order to prevent this, the rating of the fuse 9 is such that it will go open circuit at a current less than that which is necessary for the resulting heating effect to melt the solder.

The new zener diode 12 has a zener voltage which is such that it conducts when the voltage supplied to the power supply terminal 4 is greater than a predetermined value which is greater than the maximum permissible supply voltage. The resistor 11 limits the current through the zener diodes 8 and 12 and through the diode 10 so as to prevent damage to these components. The diode 10 protects the gate of the MOSFET 5 from reverse polarity voltages applied to the power supply terminal 4.

During normal operation, the circuit of Figure 2 functions in the same way as the circuit of Figure 1. However, if a thief tries to defeat the tamper-proof circuit of Figure 2 by applying relatively large voltages to the power supply terminal 4, the zener diode 12 conducts so as to forward-bias the gate of the MOSFET 5, which is therefore switched on. The MOSFET 5 therefore becomes conductive before the maximum voltage rating of the source-drain path can be exceeded and this prevents the MOSFET from being damaged by the application of excessive voltages to the power supply terminal 4.

The output of the decoder 6 may, in these circumstances, be held at the voltage of the common supply terminal 2 and act as a current sink. In the absence of the resistor 13, this could prevent the voltage at the gate of the MOSFET 5 from rising sufficiently to turn on the MOSFET. However, the presence of the resistor 13 ensures that there is a sufficient voltage at the gate to turn on the MOSFET 5 in these circumstances.

If the voltage applied to the terminal 4 is increased further in an attempt to damage the MOSFET 5, the current through the actuator, the fuse, and the source-drain path of the MOSFET 5 increases until the fuse 9 blows. The connection between the actuator 3 and the drain of the MOSFET 5 therefore becomes open circuit so that the actuator 3 cannot be operated under any circumstances. The engine cannot therefore be operated and the vehicle cannot be driven away until the tamper-resistant circuit has been replaced.

In order to ensure that the MOSFET 5 cannot be damaged by dissipating excessive power, its power rating, with heat sink if provided, must be no less than P1 or P2, where:

$$P1=(Vt/2)^2/R$$

$$P2=Vs \times 2 \times I$$

where Vt is the turn-on voltage of the network comprising the diode 10, the resistor 11, and the zener diode 12, R is the resistance of the actuator 3, Vs is the saturation voltage of the MOSFET 5, and I is the current rating of the fuse 9. The MOSFET 5 will dissipate the power P1 when turned on by an excessive voltage supplied to the terminal 4 and must be capable of withstanding this. In any event, the fuse 9 limits the maximum current which can pass through the MOSFET to twice the rating of the fuse, in which circumstances the power dissipation in the MOSFET is P2. Provided the MOSFET 5 has a maximum power dissipation such that it can dissipate P1 and P2, it cannot be damaged by the application of excessive voltages to the power supply terminal 4.

Various modifications may be made within the scope of the invention as defined by the appended claims. For instance, the network comprising the diode 10, the resistor 11, and the zener diode 12 need not be connected to the power supply terminal 4 directly but could be connected to the drain of the MOSFET 5 or to the connection between the fuse and the actuator 3. Although such an arrangement is possible, it is considered to provide less efficient protection than the arrangement shown in Figure 2. In addition, the actuator 3 and/or the fuse 9 may be connected in the source circuit of the MOSFET 5 instead of in the drain circuit as shown. Further, the MOSFET 5 may be replaced by any other suitable device, such as a bipolar transistor or a thyristor of adequate current, voltage, and power dissipation ratings. Further, the enclosure 1 may actually form part of the actuator 3 with the remaining components being provided therein.

The fuse 9 may be replaced by a thermally actuated device which goes open circuit in response to a rise in temperature corresponding to currents greater than or equal to the predetermined current. The device may be automatically or manually resettable after a delay.

It is thus possible to provide a circuit which is highly resistant to tampering. In normal use, access to the contents of the enclosure 1 is prevented other than via the connectors 4 and 7. Access to the connector 7 does not permit tampering unless the correct encoding of control signals is known. This encoding may be made different from circuit to circuit and can only be determined when the engine is operating. Assuming that a potential thief does not have access to the vehicle so as to determine the correct encoding prior to an attempt to steal the vehicle, the connector 7 cannot be used to defeat the circuit.

The application of excessive voltages to the connector 4 cannot be used to defeat the circuit. Any attempt to damage the MOSFET 5 so that it becomes a permanent short circuit is prevented by ensuring that the MOSFET turns on in the presence of such excessive voltages. Thus, the voltage rating of the source-drain circuit of the MOSFET 5 cannot be exceeded. Further, the maximum current and power dissipation ratings cannot be exceeded because the fuse 9 will first blow, thus permanently disconnecting the actuator 3 from the MOSFET 5 and ensuring that the actuator 3 can no longer be operated. The circuit may therefore be used to provide a very high degree of immunity to vehicle operation.

**Claims**

1. A semiconductor device protection circuit contained in a tamper resistant enclosure (1), the circuit comprising a load (3) which, in use, draws a first current and a semiconductor device (5), and a link (9) arranged to become open circuit at a second current which is greater than the first current, the semiconductor device (5) being capable of passing a third current which is greater than the second current, and the load (3), the link (9), and the semiconductor device (5) being connected in series between a power supply terminal (4) and a common terminal (2), the circuit further comprising means (10, 11, 12) for switching on the semiconductor device (5) when the voltage at the power supply terminal (4) relative to the common terminal (2) exceeds a predetermined voltage greater than a maximum supply voltage.

2. A circuit as claimed in Claim 1, characterised in that the link (9) is arranged to become permanently open circuit at the second current.

3. A circuit as claimed in Claim 2, characterised in that the link (9) comprises a fusible link (9).

4. A circuit as claimed in Claim 1, characterised in that the link (9) is arranged to be resettable after a predetermined delay.

5. A circuit as claimed in Claim 4, characterised in that the link (9) is automatically resettable after the predetermined delay.

6. A circuit as claimed in Claim 4, characterised in that the link (9) is manually resettable after the predetermined delay.

7. A circuit as claimed in any one of Claims 4 to 6, characterised in that the link comprises a thermally actuated device.

8. A circuit as claimed in any one of the preceding claims, characterised in that the semiconductor device (5) has a control electrode.

9. A circuit as claimed in Claim 8, characterised in that the means for switching on the semiconductor device (10, 11, 12) is connected to the control electrode of the semiconductor device (5).

10. A circuit as claimed in Claim 9, characterised in that the means for switching on the semiconductor device (10, 11, 12) is further connected to the power supply terminal (4).

11. A circuit as claimed in Claim 9 or 10, characterised in that the means for switching on the semiconductor device (10, 11, 12) comprises a zener diode (12) arranged to conduct when the voltage at the power supply terminal (4) exceeds the predetermined voltage.

12. A circuit as claimed in Claim 11, characterised in that the means for switching on the semiconductor device further comprises a resistor (11) connected in series with the zener diode (12).

13. A circuit as claimed in Claim 11 or 12, characterised in that the means for switching on the semiconductor device (10, 11, 12) further comprises a diode (10) connected in series with the zener diode (12) and arranged to prevent reverse-biasing of the control electrode.

14. A circuit as claimed in any one of Claims 8 to 13, characterised by a decoder (6) connected to the control electrode.

15. A circuit as claimed in any one of the preceding claims, characterised in that the load (3) comprises an actuator (3).

## Patentansprüche

1. Halbleitereinrichtungs-Schutzschaltung, die in einem gegenüber einer Manipulation widerstandsfähigem Gehäuse (1) enthalten ist, wobei die Schaltung eine Last (3), die bei der Verwendung einen ersten Strom zieht, und eine Halbleitereinrichtung (5) und eine Verbindung (9), die angeordnet ist, um bei einem zweiten Strom, der größer als der erste Strom ist, eine offene Schaltung zu werden, umfasst, wobei die Halbleitereinrichtung (5) einen dritten Strom führen kann, der größer als der zweite Strom ist, und wobei die Last (3), die Verbindung (9) und die Halbleitereinrichtung (5) zwischen einem Energieversorgungsanschluss (4) und einem gemeinsamen Anschluss (2) in Reihe geschaltet sind, wobei die Schaltung ferner eine Einrichtung (10, 11, 12) zum Einschalten der Halbleitereinrichtung (5), wenn die Spannung an dem Energieversorgungsanschluss (4) relativ zu dem gemeinsamen Anschluss (2) eine vorgegebene Spannung überschreitet, die größer als eine maximale Versorgungsspannung ist, umfasst.

2. Schaltung nach Anspruch 1, dadurch gekennzeichnet, dass die Verbindung (9) angeordnet ist, um bei dem zweiten Strom permanent eine offene Schaltung zu werden.

3. Schaltung nach Anspruch 2, dadurch gekennzeichnet, dass die Verbindung (9) eine schmelzbare Verbindung (9) umfasst.

4. Schaltung nach Anspruch 1, dadurch gekennzeichnet, dass die Verbindung (9) angeordnet ist, um nach einer vorgegebenen Verzögerung zurücksetzbar zu sein.

5. Schaltung nach Anspruch 4, dadurch gekennzeichnet, dass die Verbindung (9) nach der vorgegebenen Verzögerung automatisch zurücksetzbar ist.

6. Schaltung nach Anspruch 4, dadurch gekennzeichnet, dass die Verbindung (9) nach der vorgegebenen Verzögerung manuell zurücksetzbar ist.

7. Schaltung nach einem der Ansprüche 4 bis 6, dadurch gekennzeichnet, dass die Verbindung eine thermisch betätigbare Einrichtung umfasst.

8. Schaltung nach einem der vorangehenden Ansprüche, dadurch gekennzeichnet, dass die Halbleitereinrichtung (5) eine Steuerelektrode aufweist.

9. Schaltung nach Anspruch 8, dadurch gekennzeichnet, dass die Einrichtung (10, 11, 12) zum Einschalten der Halbleitereinrichtung mit der Steuerelektrode der Halbleitereinrichtung (5) verbunden ist.

10. Schaltung nach Anspruch 9, dadurch gekennzeichnet, dass die Einrichtung (10, 11, 12) zum Einschalten der Halbleitereinrichtung ferner mit dem Energieversorgungsanschluss (4) verbunden ist.

11. Schaltung nach Anspruch 9 oder 10, dadurch gekennzeichnet, dass die Einrichtung (10, 11, 12) zum Einschalten der Halbleitereinrichtung eine Zenerdiode (12) umfasst, die angeordnet ist, um zu leiten, wenn die Spannung an dem Energieversorgungsanschluss (4) die vorgegebene Spannung übersteigt.

12. Schaltung nach Anspruch 11, dadurch gekennzeichnet, dass die Einrichtung zum Einschalten der Halbleitereinrichtung ferner einen Widerstand (11) umfasst, der zu der Zenerdiode (12) in Reihe geschaltet ist.

13. Schaltung nach Anspruch 11 oder 12, dadurch gekennzeichnet, dass die Einrichtung (10, 11, 12) zum Einschalten der Halbleitereinrichtung ferner eine Diode (10) umfasst, die zu der Zenerdiode (12) in Reihe geschaltet ist und angeordnet ist, um ein Vorspannen der Steuerelektrode in Sperrrichtung zu verhindern.

14. Schaltung nach einem der Ansprüche 8 bis 13, gekennzeichnet durch einen Decoder (6), der mit der Steuerelektrode verbunden ist.

15. Schaltung nach einem der vorangehenden Ansprüche, dadurch gekennzeichnet, dass die Last (3) ein Betätigungsglied (3) umfasst.

## Revendications

1. Un circuit de protection à dispositif à semiconducteur contenu dans une enceinte inviolable (1), le circuit comprenant une charge (3) qui, pendant l'utilisation, absorbe un premier courant et un dispositif à semiconducteur (5), et une liaison (9) conçue pour passer en circuit ouvert à un second courant qui est supérieur au premier courant, le dispositif à semiconducteur (5) étant capable de faire circuler un troisième courant qui est supérieur au second courant, et la charge (3), la liaison (9) et le dispositif à semiconducteur (5) étant connectés en série entre une borne d'alimentation (4) et une borne commune (2), le circuit comprenant en outre des moyens (10, 11, 12) pour faire passer à l'état conducteur le dispositif à semiconducteur (5) lorsque la tension sur la borne d'alimentation (4), par rapport à la borne commune (2), dépasse une tension prédéterminée supérieure à une tension d'alimentation maximale.

2. Un circuit selon la revendication 1, caractérisé en ce que la liaison (9) est conçue pour passer en circuit ouvert de façon permanente au second courant.

3. Un circuit selon la revendication 2, caractérisé en ce que la liaison (9) consiste en une liaison fusible (9).

4. Un circuit selon la revendication 1, caractérisé en ce que la liaison (9) est conçue de façon à pouvoir être restaurée après un retard prédéterminé.

5. Un circuit selon la revendication 4, caractérisé en ce que la liaison (9) peut être restaurée automatiquement après le retard prédéterminé.

6. Un circuit selon la revendication 4, caractérisé en ce que la liaison (9) peut être restaurée manuellement après le retard prédéterminé.

7. Un circuit selon l'une quelconque des revendications 4 à 6, caractérisé en ce que la liaison consiste en un dispositif à actionnement thermique.

8. Un circuit selon l'une quelconque des revendications précédentes, caractérisé en ce que le dispositif à semiconducteur (5) comporte une électrode de commande.

9. Un circuit selon la revendication 8, caractérisé en ce que les moyens (10, 11, 12) pour faire passer à l'état conducteur le dispositif à semiconducteur sont connectés à l'électrode de commande du dispositif à semiconducteur (5).

10. Un circuit selon la revendication 9, caractérisé en ce que les moyens (10, 11, 12) pour faire passer à l'état conducteur le dispositif à semiconducteur sont en outre connectés à la borne d'alimentation (4).

11. Un circuit selon la revendication 9 ou 10, caractérisé en ce que les moyens (10, 11, 12) pour faire passer à l'état conducteur le dispositif à semiconducteur comprennent une diode Zener (12) conçue pour conduire lorsque la tension sur la borne d'alimentation (4) dépasse la tension prédéterminée.

12. Un circuit selon la revendication 11, caractérisé en ce que les moyens pour faire passer à l'état conducteur le dispositif à semiconducteur comprennent en outre une résistance (11) connectée en série avec la diode Zener (12).

13. Un circuit selon la revendication 11 ou 12, caractérisé en ce que les moyens (10, 11, 12) pour faire passer à l'état conducteur le dispositif à semiconducteur comprennent en outre une diode (10) connectée en série avec la diode Zener (12) et conçue pour empêcher une polarisation en inverse de l'électrode de commande.

14. Un circuit selon l'une quelconque des revendications 8 à 13, caractérisé par un décodeur (6), connecté à l'électrode de commande.

15. Un circuit selon l'une quelconque des revendications précédentes, caractérisé en ce que la charge (3) comprend un actionneur (3).

FIG 1

FIG 2